Europäisches Patentamt

**European Patent Office**

**Office européen des brevets**

(19)

(11) Numéro de publication: **0 139 585**
**B1**

(12) **FASCICULE DE BREVET EUROPEEN**

(45) Date de publication du fascicule du brevet:
24.06.87

(51) Int. Cl.⁴: **H 01 L 29/78, H 01 L 21/00**

(21) Numéro de dépôt: **84402027.1**

(22) Date de dépôt: **09.10.84**

(54) **Procédé de fabrication d'un transistor en film mince à grille auto-alignée.**

(30) Priorité: **12.10.83 FR 8316203**

(43) Date de publication de la demande:
**02.05.85 Bulletin 85/18**

(45) Mention de la délivrance du brevet:
**24.06.87 Bulletin 87/26**

(84) Etats contractants désignés:
**DE FR GB NL**

(56) Documents cités:
**EP - A - 0 076 587**
**EP - A - 0 090 661**

**IEEE ELECTRON DEVICE LETTERS, vol. EDL-3, no. 7, juillet 1982, pages 187-189, New York, USA; T. KODAMA et al.: "A self-alignment process for amorphous silicon thin film transistors"**
**SID INTERNATIONAL SYMPOSIUM-DIGEST OF TECHNICAL PAPERS, édition 1, avril 1980, pages 118-119, Lewis Winner, Coral Gables, Florida, USA; E. LUEDER: "Processing of thin film transistors with photolithography and application for displays"**

(73) Titulaire: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Chenevas-Paule, André, 42, rue de Stalingrad, F-38100 Grenoble (FR)**
Inventeur: **Diem, Bernard, 63 rue des Aiguinards, F-38240 Meylan (FR)**

(74) Mandataire: **Mongrédien, André et al, c/o BREVATOME 25, rue de Ponthieu, F-75008 Paris (FR)**

## Description

La présente invention a pour objet un procédé de fabricaton d'un transistor en film mince à grille auto-alignée.

Elle permet notamment la fabrication de composants semiconducteurs en couche mince pouvant servir à la réalisation de matrices actives pour les écrans plats à cristaux liquides, à la réalisation de matrices de photodiodes et d'une façon générale au multiplexage de composants disposés sous forme matricielle, ainsi qu'à la réalisation de dispositifs à tranfert de charge (DTC ou CCD en anglo-saxon).

Les différentes techniques connues pour la réalisation de transistors en film mince, notamment la photolithographie par alignement de masque ou l'évaporation et masquage pour des semiconducteurs de CdSe, conduisent inévitablement à l'obtention de recouvrements de la grille du transistor par la source et le drain de celui-ci. Ces recouvrements introduisent des capacités parasites dont l'importance relative croît lorsque la longueur du canal du transistor diminue. Ces capacités sont notamment préjudiciables au fonctionnement des transistors en couche mince réalisés dans du silicium amorphe hydrogéné, parce qu'elles introduisent, entre autres, une augmentation du temps de réponse du composant et un niveau de tension continue intolérable lors de l'emploi de ces composants dans des dispositifs d'affichage à cristaux liquides.

Récemment, il a été proposé un nouveau procédé de fabrication de transistor en couche mince permettant d'aligner la grille du transistor avec le drain et la source de celui-ci et donc de supprimer quasi-complètement les capacités de recouvrement. Un tel procédé a été décrit dans un article de IEEE Electron Device Letters, vol. EDL 3, n° 7 de juillet 1982, p. 187-189, intitulé «A self-alignment process for amorphous silicon thin film transistors» de T. Kodama et al.

Malheureusement, ce nouveau procédé est trop complexe pour être utilisé pour la production en masse de transistors en couche mince. En particulier, ce procédé comprend un grand nombre d'étapes ainsi qu'une phase délicate de contrôle d'interfaces, au niveau de la couche de silicium amorphe hydrogéné, qui est préjudiciable au fonctionnement ultérieur du composant (mauvais état d'interface, création d'un canal parasite, etc.). Par ailleurs, les transistors obtenus avec ce procédé ne sont nullement coplanaires «électriquement», c'est-à-dire que le canal et les électrodes du drain et de la source des transistors ne sont nullement dans un même plan.

La présente invention a justement pour objet un procédé de fabrication d'un transistor en film mince permettant de remédier à ces inconvénients. Elle permet notamment d'aligner la grille du transistor avec le drain et la source de celui-ci tout en supprimant l'interface dans la couche de silicium amorphe hydrogéné. De plus, la structure des transistors obtenus est coplanaire «électriquement».

De façon plus précise, l'invention a pour objet un procédé de fabrication d'un transistor en film mince à grille auto-alignée comprenant les étapes suivantes:

a) réalisation sur un substrat en verre de la grille du transistor;

b) dépôt, sur le substrat et la grille, d'une couche d'isolant;

c) dépôt, sur la couche d'isolant, d'une couche de silicium amorphe hydrogéné épaisse;

d) dépôt, sur la couche de silicium, d'une couche de résine photosensible positive, sensible à la lumiere ayant une longueur d'onde supérieure à 550 nanomètres;

e) irradiation de la couche de résine à travers le substrat, la grille servant de masque à l'irradiation;

f) développement de la couche de résine, conduisant à l'élimination des zones irradiées de ladite couche de résine;

g) gravure de la couche de silicium jusqu'à mise à nu de la couche d'isolant, la résine restante servant de masque à ladite gravure;

h) réalisation des contacts électriques de la source et du drain du transistor, et élimination de la résine restante, et

i) réalisation des électrodes de la source et du drain du transistor.

Le procédé de l'invention diffère du procédé décrit dans l'article précité en ce qu'une couche de silicium amorphe hydrogéné épaisse et une couche de résine positive sensible à la lumière ayant une longueur d'onde supérieure à 550 nanomètres sont utilisées et en ce que la couche de silicium est gravée jusqu'à mise à nu de la couche d'isolant avant la réalisation des contacts électriques.

L'utilisation d'une couche de silicium amorphe plus épaisse que celle utilisée dans l'article cité précédemment, permet d'éviter les problèmes d'interface au niveau de cette couche de silicium. Elle permet aussi d'obtenir une structure électriquement coplanaire.

De façon avantageuse, la couche de silicium amorphe hydrogéné présente une épaisseur de 150 à 300 nanomètres (1500 Å à 3000 Å).

L'emploi d'une résine photosensible, sensible à la lumière de longueur d'onde supérieure à 550 nanomètres et de préférence de l'ordre de 600 nanomètres, permet de diminuer, au moins d'un facteur 10, la durée d'insolation de la résine photosensible par rapport aux résines sensible à la lumière ultraviolette.

Selon un mode préféré de mise en oeuvre du procédé de l'invention, les étapes (h) et (i) comprennent les étapes suivantes:

— dépôt, sur l'ensemble de la structure, d'une couche de silicium amorphe de type $n^+$;

— dépôt, sur la couche de silicium de type $n^+$, d'une couche conductrice;

— élimination de la résine restante et des régions respectivement de la couche conductrice et de la couche de silicium de type $n^+$ situées au droit de la grille; et

— réalisation des électrodes de la source et du drain dans la couche conductrice par photolithographie.

De façon avantageuses, la couche conductrice est une couche de chrome et la couche d'isolant une couche d'oxyde de silicium.

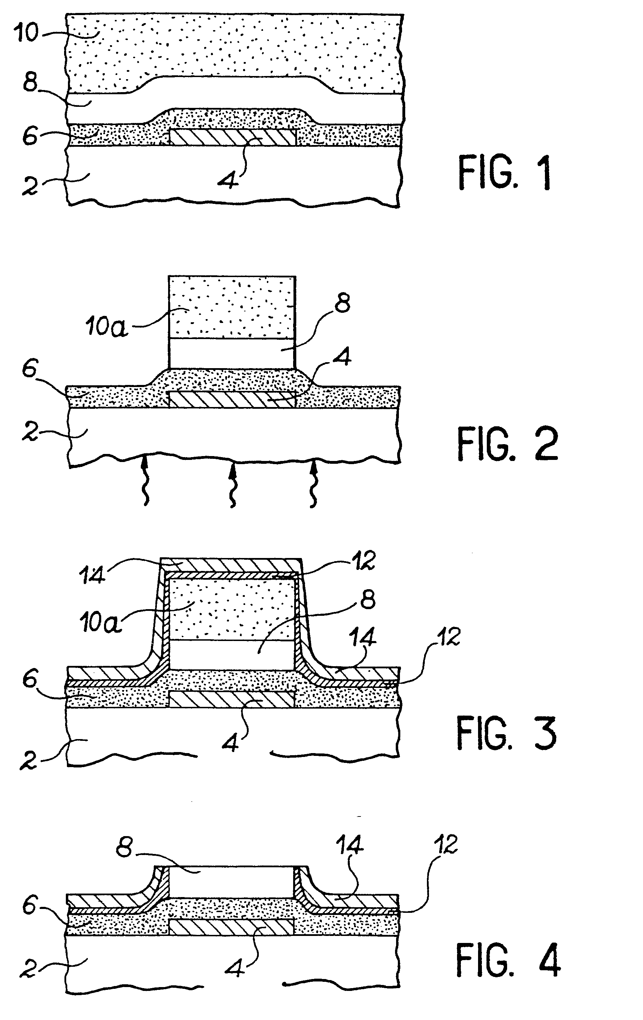

D'autres caractéristiques et avantages de l'invention ressortiront mieux de la description qui va suivre, donnée à titre illustratif mais non limitatif, en référence aux figures 1 à 4 annexées, qui illustrent les différentes étapes du procédé selon l'invention.

Comme représenté sur la figure 1, la première étape du procédé consiste à réaliser, sur un substrat en verre 2, la grille 4 du transistor en utilisant les procédés classiques de la photolithographie (masquage et gravure). Cette grille 4, présentant par exemple une épaisseur de 100 nm (1000 Å) est réalisée de préférence en chrome.

On dépose ensuite, sur le substrat 2 et la grille 4 du transistor, une couche d'isolant 6, réalisée de préférence en oxyde de silicium. Cette couche d'isolant présentant par exemple une épaisseur de 100 nm (1000 Å) peut être obtenue par la technique de dépôt chimique en phase vapeur, à basse pression ou non, ou bien par la technique de décharge luminescente, dans un appareil à radiofréquence, en utilisant un mélange gazeux de $SiH_4$ et de $O_2$.

On dépose ensuite, sur la couche d'isolant 6, une couche de silicium amorphe hydrogéné 8 épaisse, présentant avantageusement une épaisseur variant de 150 nm à 300 nm (1500 Å à 3000 Å). De préférence, l'épaisseur de la couche de silicium est voisine de 150 nm (1500 Å). Cette couche de silicium peut être obtenue par la technique de décharge luminescente en utilisant du $SiH_4$ comme gaz.

L'étape suivante du procédé consiste à déposer, sur la couche de silicium amorphe épaisse 8, une couche de résine photosensible positive 10, sensible à la lumière ayant une longueur d'onde supérieure à 550 nanomètres et par exemple comprise entre 600 et 700 nanomètres. Cette couche de résine peut être notamment déposée par centrifugation. Comme résine on peut utiliser des résines à base de phénolformaldéhyde comme celle vendue par la Société HUNT sous la référence HPR 204.

Comme représenté sur la figure 2, la couche de résine photosensible 10 est ensuite irradiée à travers le substrat 2, la grille 4 servant alors de masque à l'irradiation. L'utilisation d'une résine sensible dans le visible permet de diminuer la durée de cette irradiation. Le développement de la couche de résine permet de ne garder de cette couche que la zone 10a, située au droit de la grille du transistor, les zones irradiées étant éliminées.

L'étape suivante du procédé consiste à graver la couche de silicium amorphe hydrogéné 8, notamment par une gravure sèche en utilisant un plasma d'hexafluorure de soufre, la résine restante 10a servant de masque à ladite gravure.

Comme représenté sur la figure 3, on dépose ensuite, sur l'ensemble de la structure, une couche de silicium amorphe 12 de type $n^+$, hydrogéné ou non, présentant par exemple une épaisseur de 50 nm (500 Å). Cette couche de silicium 12, déposée par la même technique que pour le silicium amorphe hydrogéné, permet la réalisation de contacts ohmiques pour la source et le drain du transistor. Cette couche 12 est ensuite recouverte d'une couche conductrice 14 réalisée de préférence en chrome. Cette couche conductrice 14, présentant par exemple une épaisseur de 150 nm (1500 Å), est obtenue par dépôt, par exemple par évaporation sous vide ou par pulvérisation.

Au moyen de la technique connue sous l'expression anglo-saxonne «lift off», on élimine les régions respectivement de la couche conductrice 14 et de la couche de silicium de type $n^+$ 12, situées au droit de la grille 4 du transistor et la résine restante 10a. On réalise ensuite, dans ce qui reste de la couche conductrice 14, les électrodes de la source et du drain du transistor par les procédés classiques de photolithographie (masque et gravure).

Le procédé décrit précédemment, grâce à l'emploi d'une couche de silicium amorphe hydrogéné épaisse permet d'obtenr une grille auto-alignée par rapport à la source et au drain du transistor.

Il permet, de plus, d'obtenir une structure «électriquement» coplanaire, comme celle obtenue dans les transistors MOS, dans laquelle le canal du transistor et les électrodes du drain et de la source sont situés dans un même plan. Ceci permet de limiter les résistances d'accès du transistor; l'accès du canal du transistor est direct, ce qui n'est pas le cas dans les transistors de l'art antérieur.

Enfin, le procédé de l'invention est facile à mettre en oeuvre et ne présente pas d'étapes critiques.

**Revendications**

1. Procédé de fabrication d'un transistor en film mince à grille auto-lignée, comprenant les étapes suivantes;
   a) réalisation sur un substrat en verre (2) de la grille (4) du transistor;
   b) dépôt, sur le substrat (2) et la grille (4), d'une couche d'isolant (6);
   c) dépôt, sur la couche d'isolant (6), d'une couche de silicium amorphe hydrogéné épaisse (8);
   d) dépôt, sur la couche de silicium (8), d'une couche de résine photosensible positive (10), sensible à la lumière ayant une longueur d'onde supérieure à 550 nanomètres;
   e) irradiation de la couche de résine (10) à travers le substrat (2), la grille (4) servant de masque à l'irradiation;
   f) développement de la couche de résine (10), conduisant à l'élimination des zones irradiées de ladite couche de résine;
   g) gravure de la couche de silicium (8) jusqu'à mise à nu de la couche d'isolant (6), la résine restante (10a) servant de masque à ladite gravure;
   h) réalisation des contacts électriques de la source et du drain du transistor et élimination de la résine restante (10a), et
   i) réalisation des électrodes de la source et du drain du transistor.

2. Procédé de fabrication selon la revendication 1, caractérisé en ce que l'épaisseur de la couche de silicium amorphe hydrogéné (8) est de 150 nanomètres à 300 nanomètres.

3. Procédé de fabrication selon l'une quelconque des revendications 1 et 2, caractérisé en ce que la résine photosensible est sensible à la lumière ayant une longueur d'onde de l'ordre de 600 nanomètres.

4. Procédé de fabrication selon l'une quelconque des revendications 1 à 3, caractérisé en ce que les étapes h) et i) comprennent les étapes suivantes:

— dépôt, sur l'ensemble de la structure, d'une couche de silicium amorphe de type n⁺ (12);

— dépôt, sur la couche de silicium de type n⁺ (12), d'une couche conductrice (14);

— élimination de la résine restante (10a) et des régions respectivement de la couche conductrice (14) et de la couche de silicium de type n⁺ (12) situées au droit de la grille (4); et

— réalisation des électrodes de la source et du drain dans la couche conductrice (14).

5. Procédé de fabrication selon la revendication 4, caractérisé en ce que la couche conductrice (14) est une couche de chrome.

6. Procédé de fabrication selon l'une quelconque des revendications 1 à 5, caractérisé en ce que la couche d'isolant est une couche d'oxyde de silicium.


**Patentansprüche**

1. Verfahren zum Herstellen eines Dünnschichttransistors mit selbstausrichtendem Gate, welches die folgenden Schritte umfasst:

a) Herstellen des Gates (4) des Transistors auf einem Glassubstrat (2),

b) Aufbringen einer Isolierschicht (6) auf das Substrat (2) und das Gate (4),

c) Aufbringen einer dicken, Wasserstoff angereicherten Schicht (8) aus amorphem Silicium auf die Isolierschicht,

d) Aufbringen einer Schicht aus positivem, lichtempfindlichem Harz (10), welches für Licht oberhalb einer Wellenlänge von 550 nm empfindlich ist, auf die Siliciumschicht (8),

e) Bestrahlen der Harzschicht (10) durch das Substrat (2) hindurch, wobei das Gate (4) als eine Bestrahlungsmaske dient,

f) Entwickeln der Harzschicht (10), welches zum Entfernen der bestrahlten Bereiche der Harzschicht führt,

g) Ätzen der Siliciumschicht (8) bis zum Freilegen der Isolierschicht (6), wobei das verbliebene Harz (10a) als Ätzmaske dient,

h) Herstellen der elektrischen Kontakte für die Source und die Drain des Transistors und Entfernen des verbliebenen Harzes (10a), und i) Herstellen der Elektroden der Source und der Drain des Transistors.

2. Herstellungsverfahren nach Anspruch 1, dadurch gekennzeichnet, dass die Dicke der Schicht aus angereichertem, amorphem Silicium (8) 150 nm bis 300 nm beträgt.

3. Herstellungsverfahren nach Anspruch 1 oder 2, dadurch gekennzeichnet, dass das lichtempfindliche Harz für Licht mit einer Wellenlänge in der Grössenordnung von 600 nm empfindlich ist.

4. Herstellungsverfahren nach einem der Ansprüche 1 bis 3, dadurch gekennzeichnet, dass die Schritte h) und i) die folgenden Schritte umfassen:

— Aufbringen einer Schicht (12) aus amorphem Silicium vom Typ n⁺ auf die Gesamtheit der Struktur,

— Aufbringen einer leitenden Schicht (14) auf die Schicht (12) aus Silicium vom Typ n⁺,

— Entfernen des verbliebenen Harzes (10a) und der jeweiligen Bereiche der leitenden Schicht (14) und der Schicht aus Silicium vom Typ n⁺, die sich an der Stelle des Gates (4) befinden, und

— Herstellen der Elektroden der Source und der Drain in der leitenden Schicht (14).

5. Herstellungsverfahren nach Anspruch 4, dadurch gekennzeichnet, dass die leitende Schicht (14) eine Chromschicht ist.

6. Herstellungsverfahren nach einem der Ansprüche 1 bis 5, dadurch gekennzeichnet, dass die Isolierschicht eine Siliciumoxydschicht ist.


**Claims**

1. Process for the manufacture of a thin-film transistor with a self-aligned grid, comprising the following stages:

a) production of the transistor grid (4) on a glass substrate (2);

b) deposition of a layer of insulator (6) on the substrate (2) and the grid (4);

c) deposition of a thick layer of hydrogenated amorphous slicon (8) on the layer of insulator (6);

d) deposition, on the slicon layer (8), of a layer of positive photosensitive resin (10) sensitive to light of a wavelength of more than 550 nanometers;

e) irradiation of the resin layer (10) through the substrate (2), the grid (4) serving as an irradiation mask;

f) development of the resin layer (10), resulting in the removal of the irradiated regions of the said resin layer;

g) etching of the slicon layer (8) until the layer of insulator (6) is bare, the remaining rèsin (10a) serving as a mask for the said etching;

h) production of the electrical source and drain contacts of the transistor and removal of the remaining resin (10a), and

i) production of the source and drain electrodes of the transistor.

2. Manufacturing process according to Claim 1, characterized in that the thickness of the hydrogenated amorphous slicon layer (8) is from 150 nanometers to 300 nanometers.

3. Manufacturing process according to either of Claims 1 and 2, characterized in that the photosensitive resin is sensitive to light of a wavelength of the order of 600 nanometers.

4. Manufacturing process according to any one of Claims 1 to 3, characterized in that the stages h) and i) comprise the following stages:

— deposition of an n⁺ type amorphous silicon layer (12) over the whole structure;

— deposition of a conductive layer (14) on the n⁺ type silicon layer (12);

— removal of the remaining resin (10a) of the regions, respectively, of the conductive layer (14) and of the n$^+$ type silicon layer (12) which are situated opposite the grid (4); and

— production of the source and drain electrodes in the conductive layer (14).

5. Manufacturing process according to Claim 4, characterized in that the conductive layer (14) is a chromium layer.

6. Manufacturing process according to any one of Claims 1 to 5, characterized in that the layer of insulator is a silicon oxide layer.

FIG. 1

FIG. 2

FIG. 3

FIG. 4